# EUROPÄISCHE PATENTANMELDUNG

(11) **EP 2 213 757 A2**
(43) Veröffentlichungstag der Anmeldung: **04.08.2010**
(21) Anmeldenummer: 10151676.3
(22) Anmeldetag: 26.01.2010
(51) Int. Cl.: C23C 2/02, C23C 2/06, C23C 2/28, C23C 4/02, C23C 4/18, C23C 28/00, C23C 28/02

(54) **Stahlflachprodukt mit einem metallischen Überzug und Verfahren zu seiner Herstellung**

(30) Priorität: 02.02.2009 DE 102009007100
(71) Anmelder: ThyssenKrupp Steel Europe AG, 47166 Duisburg (DE)
(72) Erfinder: Nikolov, Krasimir, Dipl.-Ing., 44225 Dortmund (DE); Schuhmacher, Bernd, Dr., 44227 Dortmund (DE); Schwerdt, Christian, Dipl.-Phys., 47051 Duisburg (DE); Topalski, Slavcho, Dr., 44225 Dortmund (DE); Weiher, Nicole, Dr., 44879 Bochum (DE); Weinhold, Richard, Dipl.-Ing., 41464 Neuss (DE)
(74) Vertreter: Cohausz & Florack

(57) **Zusammenfassung**

Die Erfindung betrifft ein Stahlflachprodukt mit einer aus einem Stahlwerkstoff hergestellten Grundschicht, auf die ein metallischer Überzug aufgetragen ist, bei dem mindestens drei Schichten ausgeprägt sind, von denen mindestens zwei teilweise miteinander legiert sind, wobei der Hauptbestandteil des Überzugs Zn ist. Um bei einem solchen Stahlflachprodukt einen auch strengen Anforderungen genügenden Korrosionsschutz bei gleichzeitig guter Schweißeignung zu gewährleisten, sieht die Erfindung vor, dass die Dicke des Überzugs auf 3, 5 µm beschränkt ist, dass der Überzug neben Zn mindestens zwei Elemente der Gruppe "Al, Mg, Ti, Cr, Mn" enthält, dass in dem Überzug mindestens eine Schicht ausgebildet ist, die mindestens ein Element der Gruppe "Al, Mg" oder eine Mischung dieser Elemente mit Zink enthält, dass optional in dem Überzug eine Zn-Schicht ausgebildet ist, die mindestens zu 80 Ges.-% aus Zn besteht, dass optional in dem Überzug eine Schicht ausgebildet ist, deren Bestandteil ein Element der Gruppe "Ti, Mn, Cr" ist, und dass optional der Überzug mit einer Plasmapolymerschicht beschichtet ist. Ebenso nennt die Erfindung ein Verfahren zur Herstellung eines erfindungsgemäßen Stahlflachproduktes.

## Beschreibung

Die Erfindung betrifft ein Stahlflachprodukt mit einer aus einem Stahlwerkstoff hergestellten Grundschicht, auf die ein metallischer Überzug aufgetragen ist, der mindestens dreischichtig ausgebildet ist, wobei der Hauptbestandteil des Überzugs Zn ist. Darüber hinaus betrifft die Erfindung ein Verfahren zur Herstellung eines solchen Stahlflachproduktes.

Metallische Überzüge werden seit langem zum Schutz von Stahlblechen gegen Korrosion eingesetzt. Neben reinen Zink- oder Aluminiumüberzügen sind dazu in den letzten Jahren zunehmend binäre und ternäre Schichtsysteme entwickelt worden, die gegenüber den reinen Zink- oder Aluminiumüberzügen verbesserte Eigenschaften bieten.

Wesentliche Kriterien für den Nutzwert eines solchen Schichtsystems sind dabei die Korrosionsbeständigkeit, die Schichthaftung und die Bearbeitbarkeit des Verbundes aus Stahlblech und Schichtsystem.

So haben sich in der Praxis beispielsweise Stahlflachprodukte als besonders korrosionsbeständig bewährt, die zunächst elektrolytisch mit einer Zinkschicht beschichtet werden, auf die dann zusätzlich eine Magnesiumschicht aufgetragen wird. Die Beschichtung des elektrolytisch verzinkten Stahlblechs mit dem Mg kann dabei beispielsweise mittels Physical Vapour Deposition (PVD) im Vakuum erfolgen. Anschließend wird das Magnesium mittels einer Wärmebehandlung in die Zinkschicht unter Bildung von Zn₂Mg einlegiert.

Das so erhaltene, unter der Bezeichnung "ZE-Mg" bekannte Produkt stellt bei ausreichend großen Dicken des Überzugs einen guten Korrosionsschutz sicher. In der Praxis muss dafür allerdings aufgrund der erforderlichen Dicke der Auflage eine verminderte Schweißeignung in Kauf genommen werden. Dies zeigt sich insbesondere dann, wenn die Verschweißung mittels Laserstrahl vorgenommen werden soll. Durch eine Verminderung der Überzugsdicke kann dieses Problem zwar gemindert werden. Jedoch geht damit eine deutliche Abnahme der Korrosionsbeständigkeit in hoch verformten Zonen der Bauteile einher, die beispielsweise durch Tiefziehen aus ZE-Mg-Blechen erzeugt werden.

Ein anderes in der Praxis weit verbreitetes Überzugssystem zum Schutz vor Korrosion sind Zink-Aluminium-Legierungsüberzüge, die in der Praxis unter den Bezeichnungen "Galfan" und "Galvalume" bekannt sind. Diese Überzüge lassen sich kostengünstig durch Schmelztauchbeschichten mit gegebenenfalls nachgeschalteter Wärmebehandlung erzeugen.

In jüngerer Zeit werden in der Praxis zunehmend auch ternäre Legierungsüberzüge aus Zink, Aluminium und Magnesium, evtl. mit Beimischung geringer Mengen an Silizium, als Schmelztauchüberzüge eingesetzt. Die Schichtdicken liegen dabei jedoch mit 4 - 10 µm ebenfalls in einem Bereich, aufgrund dessen mit derartigen Überzügen versehene Stahlflachprodukte für das Laserschweißen ungeeignet sind.

Beispiele für derartige Schichtaufbauten von Korrosionsschutzüberzügen sind in der JP 06-101043 gegeben. Das dort allgemein beschriebene Mehrschichtsystem wird durch sequentielles Auftragen der einzelnen Schichten mit anschließender Diffusionswärmebehandlung hergestellt. Dazu wird zunächst auf das Stahlsubstrat eine Al-X-Legierungsschicht aufgebracht, wobei mit "X" ein Element aus der Gruppe "Mn, Ti, W, Mo, Fiel Ni, Co, Cu" bezeichnet ist und der Gewichtsanteil dieses Elements "X" an der betreffenden Schicht im Bereich von 1 - 50 % liegt. Anschließend wird ein Metall Y oder eine Legierung dieses Metalls Y auf die zuvor aufgetragene Schicht aufgebracht, wobei mit "Y" ein Element der Gruppe "Mg, Ca, Sr, Ba, Zn, Cd, In, Ti, Si, Ge, Sn, Pb, As, Sb, Bi" bezeichnet ist. Im Zuge einer Wärmebehandlung bei 100 - 500 °C ergibt sich aus den derart auf dem Stahlsubstrat abgeschiedenen Schichten ein Schichtsystem mit insgesamt 1 - 50 Gew.-% X und 0,1 - 20 Gew.-% Y. Dementsprechend ist bei diesem bekannten Schichtaufbau der Zink-Gehalt des Gesamtüberzuges auf maximal 20 Gew.-% beschränkt.

Vor dem Hintergrund des voranstehend erläuterten Standes der Technik lag der Erfindung die Aufgabe zu Grunde, einen Überzug für ein Stahlflachprodukt, wie ein Stahlblech oder Stahlband, zu schaffen, das einen auch strengen Anforderungen genügenden Korrosionsschutz bietet und gleichzeitig eine gute Schweißeignung aufweist. Darüber hinaus sollte ein Verfahren zum Herstellen eines solchen Produktes angegeben werden.

In Bezug auf das Produkt ist diese Aufgabe erfindungsgemäß dadurch gelöst worden, dass ein Stahlprodukt in der in Anspruch 1 angegebenen Weise ausgebildet ist. Vorteilhafte Ausgestaltungen eines erfindungsgemäßen Stahlflachproduktes sind in den auf Anspruch 1 rückbezogenen Ansprüchen angegeben und im Folgenden erläutert.

Ein zur Herstellung eines erfindungsgemäßen Flachproduktes besonders geeignetes, die oben genannte Aufgabe lösendes Verfahren ist durch die in Anspruch 12 genannten Verfahrensschritte gekennzeichnet. Vorteilhafte Ausgestaltungen dieses Verfahrens sind in den auf Anspruch 12 rückbezogenen Ansprüchen genannt und nachstehend erläutert.

Der auf ein erfindungsgemäßes Stahlflachprodukt aufgebrachte Überzug weist eine aus einem Stahlwerkstoff hergestellte Grundschicht auf, auf die ein metallischer Überzug aufgetragen ist. Bei diesem Überzug sind mindestens drei Schichten ausgeprägt, von denen mindestens zwei teilweise miteinander legiert sind.

Der Hauptbestandteil des erfindungsgemäßen Überzugs ist Zink. Unter Berücksichtigung dieser Maßgabe sind die Elemente, aus denen die mindestens drei metallischen Schichten des Überzuges gebildet sind, so aufeinander abgestimmt, dass sie miteinander Legierungsüberzüge bilden können.

Gemäß der Erfindung ist der Überzug so erzeugt, dass seine Dicke auf max. 3,5 µm beschränkt ist. Überzugsdicken von weniger als 3,5 µm, insbesondere von maximal 2,5 µm, erweisen sich dabei besonders vorteilhaft. Die geringe Dicke des erfindungsgemäß vorgesehenen Überzugs führt zu einer guten Schweißbarkeit von erfindungsgemäßen Stahlflachprodukten auch dann, wenn zum Schweißen ein Laserstrahl als Energiequelle verwendet wird.

Gleichzeitig ist der erfindungsgemäße Überzug so zusammengesetzt, dass er trotz seiner minimierten Dicke besonders gute Korrosionsschutzeigenschaften besitzt. Dazu enthält der Überzug neben Zn mindestens zwei Elemente, die aus der Gruppe "Al, Mg, Ti, Cr, Mn" entnommen sind.

Dabei ist in dem erfindungsgemäßen Überzug mindestens eine Schicht vorhanden, deren überwiegender Bestandteil ein Element aus der Gruppe "Al, Mg" ist. Dies schließt die Möglichkeit ein, dass eine Schicht des Überzugs durch Al dominiert wird, während in einer anderen Schicht zum überwiegenden Teil Magnesium vorhanden ist.

Des Weiteren kann in dem erfindungsgemäßen Überzug eine Zn-Schicht vorhanden sein, die zu mindestens 80 Gew.-% aus Zink besteht. Wird diese Schicht mit einer überwiegend durch Al und einer überwiegend durch Mg dominierten Schicht kombiniert, wird ein derart zusammengesetztes Schichtsystem üblicherweise als ZnAlMg-System bezeichnet, wobei die Aufeinanderfolge der einzelnen Schichten grundsätzlich beliebig ist.

Besonders gute Gebrauchseigenschaften insbesondere im Hinblick auf den Korrosionsschutz und die weitere Verarbeitbarkeit eines erfindungsgemäßen Stahlflachproduktes ergeben sich dann, wenn die Zn-Schicht zu 90 - 95 Gew.-% aus Zn besteht bzw. neben den herstellungsbedingt unvermeidbaren Verunreinigungen nur Zn enthält.

Weiter optimiert ist die Korrosionsschutzwirkung der optional in einem erfindungsgemäßen Überzug ausgebildeten Zn-Schicht, wenn ihre Dicke im Bereich von 1 - 3,3 µm liegt. Unabhängig davon, wie die Zn-Schicht aufgebracht wird, gewährleistet sie in Kombination mit den anderen Schichten des Überzugs bei dieser Schichtdicke einen optimalen Korrosionsschutz des Stahlsubstrats. Dies gilt insbesondere dann, wenn die Zn-Schicht unmittelbar auf der Grundschicht aufliegt.

Neben der mindestens einen Schicht, die mindestens ein Element der Gruppe "Al,Mg" enthält, kann alternativ oder ergänzend zu der optional enthaltenen Zn-Schicht ebenfalls optional eine weitere Schicht vorhanden sein, die mindestens ein Element der Gruppe "Ti, Mn, Cr" enthält. Sind die genannten Schichten nebeneinander vorhanden, so werden derart zusammengesetzte erfindungsgemäße Überzugssysteme als ZnAlM- oder ZnMgM-Systeme bezeichnet, wobei mit "M" eines der Elemente Ti, Mn oder Cr bezeichnet ist. Die eines dieser Elemente enthaltende Schicht ist bei einem erfindungsgemäßen Überzug typischerweise bis zu 600 nm, insbesondere 100 - 300 nm, dick.

Eine weitere deutliche Steigerung des Korrosionsschutzes lässt sich dadurch erzielen, dass der erfindungsgemäße Überzug mit einer Plasmapolymerschicht beschichtet ist.

Die wesentlichen Eigenschaften eines erfindungsgemäßen Überzugs können somit wie folgt zusammengefasst werden:
- Der Überzug weist eine Gesamtdicke von maximal 3,5 µm auf, wobei noch geringere Überzugsdicken im Hinblick auf die Gebrauchseigenschaften eines mit einem erfindungsgemäßen Überzug versehenen Stahlflachprodukts vorteilhaft sind.
- Der Überzug enthält neben Zink auch zwei Elemente der Gruppe "Al, Mg, Ti, Cr, Mn".
- der Überzug enthält mindestens eine Schicht, die überwiegend aus Aluminium, Magnesium oder einer Mischung dieser Elemente mit Zink besteht.
- Optional umfasst der Überzug eine Zn-Schicht, die zum weitaus überwiegenden Teil, bevorzugt weitestgehend vollständig, aus Zn besteht.
- Optional ist in dem Überzug eine Schicht ausgebildet, die mindestens ein Element der Gruppe "Ti,Mn,Cr" enthält, wobei diese Elemente jeweils alle diese Schicht bilden können oder in Kombination miteinander oder mit Zn.
- Durch eine Wärmebehandlung sind mindestens zwei der Schichten des Überzugs miteinander zumindest teilweise legiert.
- Schließlich ist auf den Überzug optional auch noch eine Plasmapolymerschicht aufgebracht, die vor oder nach der Wärmebehandlung auf dem Überzug abgeschieden wird.

Mit der Erfindung steht somit ein Stahlflachprodukt zur Verfügung, bei dem eine hohe Korrosionsbeständigkeit, insbesondere im Flanschkorrosionstest, und eine sehr gute Verarbeitbarkeit, insbesondere Schweißbarkeit, miteinander kombiniert sind. Die minimierte Dicke des erfindungsgemäßen Überzugs bewirkt dabei eine deutlich verbesserte Laserschweißeignung gegenüber den eingangs diskutierten bekannten Schichtsystemen. Durch umfangreiche Untersuchungen konnte belegt werden, dass ein erfindungsgemäß dreischichtig aufgebauter Überzug trotz seiner geringen Dicke einen Korrosionsschutz bietet, wie er sonst nur bei deutlich dickeren Schutzüberzügen erzielt wird, deren Dicke typischerweise 7,5 µm und mehr beträgt.

Die Erfindung nutzt die unterschiedlichen Eigenschaften der einzelnen Bestandteile eines erfindungsgemäßen Überzugs und kombiniert diese so, dass ein im Hinblick auf die Gebrauchseigenschaften optimales Ergebnis erzielt wird. So weist ein erfindungsgemäßes Stahlflachprodukt eine hohe Korrosionsbeständigkeit sowohl in blankem Zustand als auch in Kombination mit organischen Beschichtungen auf. Diese hervorragende Korrosionsstabilität bewährt sich insbesondere in Flanschen und Hohlräumen.

Des Weiteren lassen sich erfindungsgemäß beschichtete Stahlflachprodukte mit Hilfe von Laserstrahlen besonders sicher verschweißen. Dies zeigte sich dadurch, dass lochfreie Lasernähte ohne bzw. mit nur sehr geringen Anteilen an Poren und/oder Auswurfkratern bei einem technischen Fügespalt von 0 mm und Schweißgeschwindigkeiten deutlich höher als 5 m/min erzielt werden konnten.

Darüber hinaus zeichnet sich das erfindungsgemäße Dünnschichtsystem durch einen hervorragenden temporären Korrosionsschutz aus, so dass keine speziellen Konservierungsmaßnahmen, wie z. B. Konservierung mittels eines Korrosionsschutzöls für die mit diesem Dünnschichtsystem versehenen Stahlbleche oder -bänder vor ihrer Endverarbeitung notwendig sind.

Eine weitere hervorragende Eigenschaft, die ein erfindungsgemäßes Stahlflachprodukt besitzt, zeigt sich, wenn ein solches Blech oder Band unmittelbar (ohne Phosphatierung und Passivierung) mittels kathodischer Tauchlackierung (KTL) lackiert wird. Dies gilt insbesondere dann, wenn das Stahlflachprodukt zusätzlich zu dem erfindungsgemäß ausgebildeten metallischen Überzug mit einer Plasmapolymerschicht beschichtet ist. Insbesondere dann ergibt ein in Anlehnung an DIN EN ISO 6860 durchgeführter Dornbiegetest für erfindungsgemäße Bleche oder Bänder ein hervorragendes Lackanhaftungsvermögen. Es zeigen sich keine Lackabplatzungen und auch keine Abplatzungen des Überzugs vom Grundmaterial.

Aufgrund ihres Eigenschaftsspektrums eignen sich erfindungsgemäß beschichtete Stahlflachprodukte im besonderen Maße für die Verwendung im Karosseriebau, insbesondere im Automobilkarosseriebau, oder auch für die Herstellung von Haushaltsgeräten. Der Korrosionsschutz eines erfindungsgemäßen Überzugs ist dabei so hoch, dass derart geschützte Stahlfeinbleche in Flanschproben gemäß Stahl-Eisen-Prüfblatt SEP 1160 eine Korrosionsbelastung von mindestens 7 Zyklen und mehr im Korrosionswechseltest gemäß VDA 621-415 ohne Rotrostbildung überstehen.

Mit Hilfe der gegebenenfalls optional vorhandenen zusätzlichen Plasmapolymerbeschichtung ergibt sich ein Eigenschaftsprofil, bei dem gute funktionelle Eigenschaften des metallischen Überzugs, wie z. B. einer hervorragenden Korrosionsbeständigkeit sowohl im blanken Zustand als auch in Kombination mit organischen Beschichtungen, insbesondere hervorragende Korrosionsstabilität in Flanschen und Hohlräumen, mit optimierten Verarbeitungseigenschaften, wie z. B. Punktund insbesondere uneingeschränkte Laserschweißeignung sowie unmittelbare (ohne Phosphatierung und/oder Passivierung) kathodische Elektrotauchlackierbarkeit (KTL) gepaart sind. Flansche, die aus Stahlflachprodukten gezogen sind, die neben einem erfindungsgemäß aufgebauten metallischen Überzug auch noch mit einer erfindungsgemäß optional vorgesehenen Plasmapolymerschicht überzogen sind, weisen auch nach 20 Zyklen und mehr im Korrosionswechseltest gemäß VDA 621-415 keine Rotrostbildung auf.

Überraschend hat sich gezeigt, dass ein erfindungsgemäß ausgebildeter Überzug auch dann noch strengen Anforderungen genügenden Korrosionsschutz bietet, wenn die Dicke des Überzugs weniger als 2,5 µm beträgt, insbesondere im Bereich von 1 - 2,4 µm liegt. Dabei gilt, dass die Eignung zum Verschweißen mittels Laserstrahl umso mehr zunimmt, je dünner der Überzug ist.

Abhängig von den jeweils in den Vordergrund zu stellenden Eigenschaften kann das auf einem erfindungsgemäßen Stahlflachprodukt als Überzug vorhandene Schichtsystem so ausgebildet werden, dass die Eigenschaften seiner einzelnen Schichten durch den Einfluss eines einzigen oder das kombinierte Wirken von zwei oder mehr Elementen bestimmt wird.

Gemäß einer ersten Variante der Erfindung besteht dazu beispielsweise die ein Element der Gruppe "Al,Mg" oder eine Mischung dieser Elemente mit Zn enthaltende Schicht zu mindestens 60 Gew.-% aus MgZn₂. Neben der metallischen Phase MgZn₂ können dabei auch noch geringere Mengen an der metallischen Phase Mg₂Zn₁₁ vorhanden sein. Durch den hohen Anteil an stabilen MgZn₂-Phasen ist ein besonders guter Korrosionsschutz bei gleichzeitig optimiertem Haftungsvermögen und Abriebverhalten gewährleistet. Gleichzeitig ist durch den hohen Anteil an MgZn₂-Phasen sichergestellt, dass die instabilere Mg₂Zn₁₁-Phase nur in so geringen Mengen vorhanden ist, dass sie die Korrosionsschutzwirkung des Überzuges nicht beeinträchtigen.

Alternativ kann es auch zweckmäßig sein, wenn die ein Element der Gruppe "Al,Mg" oder eine Mischung dieser Elemente mit Zn enthaltende Schicht eine Al-Zn-Schicht ist, die zu mindestens 60 Gew.-% aus Zn besteht. Durch den hohen Zn-Anteil in Kombination mit Al wird einerseits erreicht, dass die Korrosionsbeständigkeit beispielsweise im Flansch erhöht ist. Andererseits ist bei einer Begrenzung des Al-Gehaltes der Al-Zn-Schicht auf maximal 20 Gew.-% Al nach wie vor gewährleistet, dass die Al-Zn-Schicht an Schichtdefekten, wie beispielsweise an Ritzen, Rissen oder vergleichbaren Störungen, das Stahlsubstrat kathodisch schützt, also als Opferanode fungiert. Diese verbesserte Schutzwirkung wird dann besonders sicher erreicht, wenn der Zn-Anteil der Zn-Al-Schicht mindestens 80 Gew.-% beträgt.

Wenn dagegen die ein Element der Gruppe "Al,Mg" oder eine Mischung dieser Elemente mit Zn enthaltende Schicht zu mindestens 50 Gew.-% aus Al besteht, wird die passivierende Wirkung von Aluminium betont. Kommt es zur Freilegung dieser Schicht, so bildet sich extrem korrosionsbeständiges Aluminiumoxid bei Luftkontakt. Deshalb wirkt sich diese Schicht auch als zusätzliche Barriereschicht unterhalb der Zinkschicht besonders vorteilhaft auf die Eigenschaften einer erfindungsgemäßen Beschichtung aus.

Eine hoch effektive Kombination der voranstehend angegebenen Eigenschaften der ein Element aus der Gruppe "Al,Mg" oder eine Mischung dieser Elemente mit Zink enthaltenden Schicht ergibt sich dann, wenn die betreffende Schicht ternäres Gemisch aus Zink, Aluminium und MgZn₂ bildet, wobei in geringerer Menge zusätzliche metallische Phasen, wie beispielsweise Mg₂Zn₁₁, vorhanden sein können.

Praktische Untersuchungen haben ergeben, dass die in einem erfindungsgemäßen Überzug durch die ein Element der Gruppe "Al,Mg" oder einer Mischung dieser Elemente mit Zn enthaltende Schicht erzielten Wirkungen bereits dann sicher eintreten, wenn die Dicke dieser Schicht auf max. 1000 nm beschränkt ist. Eine optimale Abstimmung der Sicherheit einerseits, mit der die Wirkung der Al- und/oder Mg-enthaltenden Schicht genutzt werden kann, und der erfindungsgemäß angestrebten Minimierung der Gesamtdicke des Überzugs andererseits ergibt sich dann, wenn die Schichtdicke auf 200 - 600 nm beschränkt ist.

Indem mindestens zwei der Schichten des Überzugs der jeweils überwiegende Bestandteil dieser Schichten mit dem überwiegenden Bestandteil der jeweils angrenzenden Schicht mindestens teilweise legiert ist, werden die jeweiligen metallische Phasen und Strukturen zusammengebracht, um bestimmte korrosionsschützende Eigenschaftskombinationen zu erzielen. Als Beispiel kann hier die Bildung von MgZn₂ genannt werden, wenn eine Mghaltige Schicht mit der Zn-Schicht teilweise legiert wird.

Eine an die Grundschicht angrenzende Schicht des erfindungsgemäßen Überzugs, die zum überwiegenden Teil aus Al besteht, wirkt als Sperrschicht, die die Bildung von Eisen-Zink-Phasen verhindert. Dementsprechend sieht eine Ausgestaltung der Erfindung vor, dass die an die Grundschicht angrenzende Schicht des erfindungsgemäßen Überzuges zum überwiegenden Teil, insbesondere im Wesentlichen vollständig, aus Aluminium besteht. Dabei hat sich gezeigt, dass sich die Schutzwirkung der Al-Schicht bei gleichzeitig minimierte Dicke des Überzugs dann besonders sicher entfalten kann, wenn sie bis zu 600 nm, insbesondere 100 - 400 nm, dick ist. Eine solche Aluminiumsperrschicht kann beispielsweise durch eine gezielt im Rahmen einer Wärmebehandlung bewirkte schnelle Diffusion durch die jeweils vorhandene Zinkschicht oder durch gezieltes Abscheiden einer Aluminiumschicht bei der Herstellung des Überzuges erzeugt werden.

Ein vergleichbarer, den Korrosionsschutz durch eine Sperrwirkung unterstützender Effekt kann dadurch erzielt werden, dass die an die Grundschicht angrenzende Schicht des erfindungsgemäßen Überzuges zum überwiegenden Teil, insbesondere im Wesentlichen vollständig, aus Chrom besteht. Wenn diese Cr-Schicht bis zu 600 nm, insbesondere 100 - 250 nm, dick ist, lässt sich bei gleichzeitig minimierter Dicke des Überzugs der den Korrosionsschutz unterstützende Effekt der Chrom-Schicht besonders sicher nutzen.

Tests haben belegt, dass besonders in solchen Fällen, in denen die mindestens eines der Elemente Ti, Mn oder Cr enthaltende Schicht außen an der Oberfläche des Überzugs liegt, der erfindungsgemäße Überzug besonders gute Korrosionsschutzeigenschaften aufweist.

Für erfindungsgemäße Überzüge, bei denen eine Schicht ausgebildet ist, deren überwiegender Bestandteil Ti ist, konnten besonders gute Korrosionsschutzeigenschaften nachgewiesen werden. Dies gilt überraschender Weise bereits dann, wenn die Dicke der Ti-Schicht auf max. 500 nm beschränkt ist, insbesondere im Bereich von 100 - 300 nm liegt.

Eine besonders sichere Wirkung des jeweiligen Elements hinsichtlich des Korrosionsschutzes kann dadurch erreicht werden, dass die mindestens ein Element der Gruppe "Ti, Mn, Cr" enthaltende Schicht zu mindestens 75 Gew.-% aus dem jeweiligen Element besteht.

Im Fall, dass eine mindestens ein Element der Gruppe "Ti,Mn,Cr" enthaltende Schicht vorhanden ist, hat es sich im Hinblick auf das Haftungsvermögen und die Korrosionsschutzwirkung als vorteilhaft herausgestellt, wenn zu einer der an diese Schicht angrenzenden Schichten des Überzugs ein Übergangsbereich ausgebildet ist, in dem die Schichten gradiert ineinander legiert sind. Auf diese Weise bilden die aneinander liegenden Schichten einen innigen Verbund, bei dem es keinen klar definierten, sich sprunghaft einstellenden Unterschied zwischen den einzelnen Schichten gibt. Stattdessen gehen die aneinander anliegenden Schichten nach Art eines fließenden Übergangs ineinander über. Besonders sicher stellt sich die vorteilhafte Wirkung auch unter Berücksichtigung der erfindungsgemäß minimierten Gesamtdicke des Überzugs dann ein, wenn der Übergangsbereich max. 1500 nm dick ist.

Eine weitere Ausgestaltung der Erfindung ist **dadurch gekennzeichnet, dass** die Schichten des Überzugs neben unvermeidbaren Verunreinigungen aus den Bestandteilen Zn und Al sowie mindestens einem Element aus der Gruppe "Mg, Ti, Cr, Mn" gebildet sind. Diese Variante der Erfindung umfasst Überzüge, bei denen der überwiegende Bestand jeweils einer der Schichten Zn und einer anderen Schicht Al ist, während die dritte Schicht zum überwiegenden Teil aus Mg, Ti, Cr oder Mn gebildet sein kann. Die entsprechenden Überzüge werden als "ZnAlMg-", "ZnAlTi-", "ZnAlCr-" oder "ZnAlMn-Überzüge" bezeichnet.

Eine optimale ergänzende Schutzwirkung der Plasmapolymerschicht bei gleichzeitig guter Schweißeignung des neben dem erfindungsgemäßen Überzug mit einer solchen zusätzlichen Schicht versehenen Stahlflachprodukts ergibt sich dann, wenn die Dicke der Plasmapolymerschicht höchstens 1500 nm beträgt. Bevorzugt beträgt die Dicke der Plasmapolymerschicht nur bis zu 1000 nm, wobei sich eine optimierte Wirkung bei gleichzeitig optimal verminderter Dicke der Plasmapolymerschicht dann ergibt, wenn die Dicke dieser Schicht im Bereich von 100 - 500 nm liegt.

Bei der Plasmapolymerschicht kann es sich beispielsweise um ein Si-C-H- oder ein Si-O-C-H-Netzwerk oder eine Mischung aus diesen Netzwerken handeln. Dabei konnte in praktischen Versuchen eine besonders gute Wirkung einer solchen Plasmapolymerschicht nachgewiesen werden, wenn die Plasmapolymerschicht eine röntgenamorphe oder röntgenamorph-nanokristalline Hybridstruktur besitzt.

Für die Herstellung erfindungsgemäß ausgebildeter Stahlflachprodukte wird ein Stahlsubstrat in Form eines Bandes oder Blechs zu Verfügung gestellt.

Dieses Stahlsubstrat wird unter einer insbesondere aus einem Stickstoff-Wasserstoff-Gemisch gebildeten, reduzierenden Atmosphäre geglüht, um eine für den nachfolgenden Beschichtungsschritt optimale Oberflächenbeschaffenheit und Struktur des Stahlsubstrats zu erzeugen. Die reduzierende Atmosphäre dient dabei dazu, Verunreinigungen, insbesondere Oxide, aus der Oberfläche des Stahlsubstrats zu entfernen. Durch die genaue Einstellung der Glühparameter (Taupunkt, Temperatur, etc.) ist es möglich, beim Glühprozess die Anreicherung von Legierungsbestandteilen des Stahlsubstrats an der Oberfläche zu vermeiden und eine nahezu reine Eisenoberfläche zu erzeugen, was sich vorteilhaft auf die Haftung des Schichtsystems auf dem Stahlsubstrat auswirkt.

Alternativ oder ergänzend zu der Glühung kann die Vorbereitung des jeweiligen Stahlsubstrats durch eine Plasmavorbehandlung erfolgen. Dazu können beispielsweise ein inverses Magnetron-Sputtern oder ein AEGD-Verfahren (AEGD = Arc Enhanced Glow Discharge) eingesetzt werden.

Anschließend wird das Stahlsubstrat mit mindestens drei unterschiedlichen Schichten beschichtet. Die Beschichtung mit der mindestens einen Schicht, deren überwiegender Bestandteil Al oder Mg ist, sowie die Beschichtung mit der optional zu erzeugenden Schicht, deren überwiegender Bestandteil Ti, Cr oder Mn ist, werden dabei durch ein unter Niederdruck durchgeführtes Abscheideverfahren aufgebracht. Verfahren dieser Art erlauben es, besonders dünne und dennoch gleichmäßige Schichten aus metallischen Werkstoffen auf dem Stahlsubstrat bzw. eine darauf bereits in einem vorangegangen Beschichtungsschritt erzeugten Schicht aufzutragen.

Zu betonen ist in diesem Zusammenhang, dass die Erfindung keine bestimmte Reihenfolge des Schichtaufbaus voraussetzt, sondern es erlaubt, den Schichtaufbau so zu wählen, dass er die ihm jeweils zugedachte Funktion optimal erfüllt.

Für die Abscheidung der mindestens zwei unter Vakuum erzeugten Schichten kommen Vakuumbeschichtungsprozesse, wie thermische Aufdampfung, Elektronenstrahl-Verdampfung, Arc-Verdampfung, Laser-Verdampfung, Zerstäubung oder Magnetronzerstäubung, in ihren klassischen, modifizierten oder kombinierten Varianten, oder mittels eines kombinierten Verfahrens aus elektrolytischen, Schmelztauch- und Vakuumbeschichtungsprozessen in Frage. Besonders praxisgerecht lässt sich beispielsweise das bekannte Physical Vapour Deposition (PVD) - Verfahren einsetzen. Dabei handelt es sich um ein Verfahren, bei dem im Vakuum Metalle verdampft werden und sich auf dem Stahlsubstrat abscheiden. Für die Verdampfung und Abscheidung des die jeweilige Schicht bildenden Metallwerkstoffs stehen dabei unterschiedliche Möglichkeiten zur Verfügung. Neben der klassischen thermischen Verdampfung, bei der die Metalle resistiv, induktiv oder mittels Elektronenstrahl verdampft werden, gibt es die Möglichkeit, mittels Sputtern Schichten aufzubringen. Insbesondere bei thermischem Verdampfen besteht darüber hinaus die Möglichkeit, entweder nacheinander Schichten mittels separaten Verdampfern zu erzeugen oder durch gleichzeitiges Verdampfen verschiedener Metalle legierte Schichtsysteme herzustellen.

Im Fall, dass die Herstellung des Schichtsystems ausschließlich mittels PVD-Technik erfolgt, sollte das Stahlsubstrat bei der dem Schichtauftrag vorangehenden Glühung rekristallisierend geglüht werden, wobei diese Glühung bevorzugt unter einer 95 % N2 und 5 % H2 enthaltenden Atmosphäre durchgeführt wird. Alternativ ist es auch möglich, die rekristallisierende Glühung im Vakuum durchzuführen, um eine Oberflächenoxidation zu vermeiden.

Anschließend wird das Stahlsubstrat auf eine zur Beschichtung geeignete Temperatur abgekühlt, die abhängig von der Zusammensetzung des Stahlsubstrats und der nachfolgend verarbeiteten Metalle sowie der zum Beschichten gewählten Technologie typischerweise zwischen 20 °C und 500 °C liegt. Das auf eine in diesem Bereich liegende Temperatur abgekühlte Stahlsubstrat kann dann im Vakuum nacheinander mit den jeweiligen Metallen beschichtet werden.

Eine wichtige Ausgestaltung des erfindungsgemäßen Verfahrens besteht auch in der Möglichkeit, drei nacheinander geschaltete PVD-Prozesse mit einer Contiglühe zu verbinden. Dabei findet durch ein rekristallisierendes Glühen in einer reaktiven Atmosphäre eine Oberflächenaktivierung statt, bevor nach einer Abkühlung auf eine für die Bedampfung geeignete Substrattemperatur mittels PVD mindestens drei metallische Schichten auf das Stahlsubstrat aufgebracht werden.

Im Hinblick auf eine möglichst exakte feine Einstellung der Schichtdicken ist es günstig, wenn alle Schichten eines erfindungsgemäßen Überzugs mit Hilfe der PVD-Technologie oder vergleichbarer Verfahren aufgebracht werden, mit denen extrem dünne und dennoch dichte Schichten erzeugt werden können. Unter Kostengesichtspunkten kann es jedoch auch zweckmäßig sein, erfindungsgemäße Stahlflachprodukte unter Verwendung einer konventionellen Anlage zum elektrolytischen Verzinken mit einer durch Zink dominierten Schicht zu versehen, während die beiden anderen Schichten durch PVD oder ein vergleichbares Verfahren aufgetragen werden. Durch elektrolytisches Verzinken kann auf dem Stahlsubstrat selbst oder auf einer zuvor auf das Stahlsubstrat aufgetragenen Schicht eine Zinkschicht erzeugt werden, deren Dicke fein auf einen Dickenbereich justiert werden kann, der innerhalb der erfindungsgemäßen Vorgaben liegt. Grundsätzlich ist es darüber hinaus möglich, eine Zinkschicht auch durch Schmelztauchbeschichten auf das Stahlsubstrat aufzubringen, wenn es gelingt, dabei die von der Erfindung geforderte geringe Dicke der Zn-Schicht einzustellen.

Nach dem Auftragen der mindestens drei Schichten wird im Zuge des erfindungsgemäßen Verfahrens eine Wärmebehandlung des mit den mindestens drei Schichten belegten Stahlsubstrats durchgeführt. Ziel dieser Wärmebehandlung ist, dass ein dreischichtiger Überzug ausgebildet wird, bei dem mindestens zwei Schichten mindestens teilweise miteinander legiert sind. Durch die Dauer und die Temperatur des Diffusionsprozesses wird dabei ein gezieltes Schichtdesign erreicht. Besonders gute Ergebnisse ergeben sich dabei dann, wenn die Temperatur der Wärmebehandlung des Überzugs weniger als 500 °C beträgt, insbesondere im Bereich von 150 - 450 °C liegt. Dabei stellt sich der von der Erfindung geforderte Schichtaufbau des Überzuges dann besonders sicher ein, wenn die Temperatur der Wärmebehandlung 260 - 360 °C beträgt, insbesondere im Bereich von 290 - 330 °C liegt. In diesen Temperaturbereichen setzen Diffusionsvorgänge ein, durch die sich der erfindungsgemäß vorgegebene Schichtaufbau des auf dem Stahlsubstrat erzeugten Überzugs ausbildet.

Um die erfindungsgemäße Ausbildung des Schichtaufbaus sicher zu erzielen, sollte die Wärmebehandlung in weniger als 60 Sekunden abgeschlossen werden Die kurze Behandlungsdauer von weniger als 60 s, insbesondere von weniger als 30 s, erlaubt es, Diffusionsprozesse zu stoppen und die Bildung bestimmter Phasen zu unterdrücken, die bei längeren Wärmebehandlungsprozessen entstehen würden. So könnten sich beispielsweise im Fall, dass ein verzinktes Blechmaterial als Ausgangsprodukt für eine erfindungsgemäße Beschichtung genutzt wird, bei einer längeren Wärmebehandlung Eisen-Zink-Phasen bilden, die eine schlechte Haftung des Überzuges auf dem jeweiligen Stahlflachprodukt zur Folge hätten.

Abschließend kann dann optional eine Plasmapolymerschicht auf den nach der Wärmebehandlung erhaltenen Überzug aufgetragen werden. Dies kann beispielsweise mittels einer gepulsten Gleichstrom-Hohlkatoden-Glimmentladung erfolgen, wobei die Abscheidung bevorzugt unter Verwendung von Organosilan- oder Kohlenwasserstoff- oder organometallischen Verbindungen oder einer ihrer Mischungen erfolgt.

Eine besonders wirtschaftliche Variante des erfindungsgemäßen Verfahrens ergibt sich dabei dann, wenn die Wärmebehandlung der mindestens drei metallischen Schichten des Überzugs vor dem Auftrag der Plasmapolymerschicht, nach dem Auftrag der Plasmapolymerschicht oder gleichzeitig mit der Beschichtung mit Plasmapolymer durchgeführt wird.

Im Fall, dass das erfindungsgemäße mindestens ternäre Überzugssystem aus den wesentlichen Bestandteilen Al, Mg, Zn gebildet ist, von denen mindestens zwei der drei Schichten mit PVD aufgetragen werden, ergeben sich bei folgenden Auflagengewichten besonders gute Eigenschaften des erfindungsgemäßen Überzuges:

| | |
|---|---|
| Al: | 0,4 - 1,1 g/m² |
| Zn: | 7 - 18 g/m² |
| Mg: | 0,15 - 1,4 g/m² |

Bei diesen Auflagengewichten ergibt sich für die Aldominierte Schicht eine Dicke von 50 - 400 nm, für Zn-Schicht eine Dicke von 1 - 2,4 µm und für die Mg-Schicht eine Dicke von bis zu 100 - 800 nm.

Das erfindungsgemäße Verfahren eignet sich im besonderen Maße zur Durchführung im Durchlauf, wobei hohe Abscheideraten erzielt werden. So lassen sich die Arbeitsschritte eines erfindungsgemäßen Verfahrens vorzugsweise in vorhandene Durchlaufbeschichtungsanlagen integrieren. Die erfindungsgemäßen Dünnschichtsysteme ermöglichen dabei aufgrund ihrer reduzierten Schichtdicken eine weitere signifikante Steigerung der Banddurchlaufgeschwindigkeit, wodurch eine besonders hohe Produktivität erreicht wird.

Ausgehend vom Produkt ZE-Mg zeigen erste Versuche mit dem System ZE-Mg-Al vielversprechende Ergebnisse. Das Ziel besteht darin, nacheinander drei (oder mehr) Schichten (Aluminium, Zinks Magnesium) auf Stahlfeinblech aufzubringen und anschließend mittels einer geeigneten Wärmebehandlung einen gezielten Diffusionsprozess durchzuführen.

Als typische Beispiele für den Schichtaufbau eines bei einem erfindungsgemäßen Stahlflachprodukt vorhandenen Überzugs sind:

### 1. Schichtsystem Zink-Aluminium-Magnesium (Variante A)

Bei diesem erfindungsgemäßen Schichtsystem liegt eine ca. 100 - 600 nm dicke Al-Zn-Schicht auf der Grundschicht. Auf dieser Al-Zn-Schicht liegt eine zu mindestens 80 Gew.-% aus Zn bestehende Zn-Schicht. Auf der Zn-Schicht liegt wiederrum eine Zn-Al-Mg-Schicht, die den Abschluss des Überzugs nach außen bildet. Die drei Schichten des Überzugs sind dabei teilweise miteinander legiert, wodurch ein besonders guter Zusammenhalt auch bei hohen Verformungsgraden gewährleistet ist. Gleichzeitig bilden die auf der Stahlsubstrat-Grundschicht aufliegende Al-Zn-Schicht eine Barrier, die die Grundschicht effektiv vor Korrosion schützt.

Dieses Zn-Al-Mg-Schichtsystem kann dadurch erzeugt werden, dass das die Grundschicht bildende Stahlsubstrat (Stahlband oder -blech) zunächst elektrolytisch verzinkt wird, anschließend Magnesium und Aluminium aufgedampft werden und dann eine Wärmbehandlung bei ca. 360 °C durchgeführt wird, bei der sich der hier beschriebene erfindungsgemäße Schichtaufbau bildet. Optimaler Weise erfolgt dabei vor der Bedampfung eine Plasmafeinreinigung der elektrolytisch aufgetragenen Zn-Schicht.

### 2. Schichtsystem Zink-Aluminium-Magnesium (Variante B)

Bei diesem erfindungsgemäßen Schichtsystem weist der Überzug eine auf der Stahlsubstrat-Grundschicht aufliegende, überwiegend aus Al bestehende und 100 - 400 nm dicke Al-Schicht, eine auf der Al-Schicht aufliegende, zu mindestens 80 Gew.-% und maximal 1000 nm dicke, aus Zn bestehende Zn-Schicht und eine auf der Zn-Schicht aufliegende, 200 - 600 nm dicke Zn-Mg-Schicht auf, die überwiegend aus MgZn₂ und gegebenenfalls zusätzlich vorhandenen Anteilen an Mg₂Zn₁₁ gebildet ist. Die Al-Schicht und die Zn-Schicht können dabei in einem Übergangsbereich gradiert ineinander legiert sein.

Das Zn-Al-Mg-Schichtsystem kann hier dadurch erzeugt werden, dass das die Grundschicht bildende jeweilige Stahlsubstrat (Stahlband oder -blech) rekristallisierend geglüht und / oder mit einer Plasmafeinreinigung vorbehandelt, dann nacheinander durch PVD-Abscheidung oder ein anderes Vakuum-Abscheideverfahren mit Al, Zn und Mg beschichtet und schließlich bei 290 - 330 °C wärmebehandelt wird, um den beschriebenen erfindungsgemäßen Schichtaufbau des Überzugs herzustellen.

### 3. Schichtsystem Zink-Chrom-Magnesium

Auf einem als Grundschicht dienenden Stahlsubstrat (Stahlband oder -blech) liegt eine 100 - 400 nm dicke Chrom-Schicht, auf der wiederum eine Zink-Schicht liegt, die gegenüber der Umgebung durch eine Zink-Magnesium-Schicht abgedeckt ist, welche max. 1000 nm, insbesondere 200 - 600 nm dick ist und überwiegend aus MgZn₂ sowie eventuell zusätzlich vorhandenem Mg₂Zn₁₁ besteht.

Das erfindungsgemäße Zn-Cr-Mg-Schichtsystem kann hier dadurch erzeugt werden, dass das jeweilige Stahlsubstrat zunächst rekristallisierend geglüht und / oder mit einer Plasmafeinreinigung vorbehandelt wird, dass anschließend mit einem PVD-Verfahren nacheinander Cr, Zn und Mg auf dem Stahlsubstrat abgeschieden werden und dass schließlich bei einer Temperatur von 290 - 330 °C eine Wärmebehandlung durchgeführt wird, bei der sich der erfindungsgemäße Aufbau des Überzugs einstellt.

### 4. Schichtsystem Zink-Titan-Magnesium

Das erfindungsgemäße Schichtsystem besteht hier aus einer auf der Grundschicht aufliegenden Zn-Schicht, einer darauf liegenden, höchstens 1000 nm, insbesondere 200 nm bis 600 nm, dicken Zink-Magnesium-Schicht, die überwiegend aus MgZn₂ sowie eventuell zusätzlich vorhandenem Mg₂Zn₁₁ besteht, und einer darauf liegenden Titan-Deckschicht, die weniger als 500 nm, insbesondere 100 - 300 nm, dick ist.

Dieses erfindungsgemäße Zn-Ti-Mg-Schichtsystem kann dadurch erzeugt werden, dass das jeweilige Stahlsubstrat zunächst elektrolytisch verzinkt wird, dass darauf dann nacheinander Magnesium und Titan mit einem PVD-Verfahren abgeschieden werden und schließlich bei einer Temperatur von ca. 330 °C eine Wärmebehandlung durchgeführt wird, bei der sich der erfindungsgemäße Aufbau des Überzugs einstellt.

Jeder der voranstehend beispielshaft angegebenen Schichtaufbauten kann zur weiteren Verbesserung des Korrosionsschutzes mit einer maximal 1500 nm dicken Plasmapoylmerschicht beschichtet werden. Dies kann beispielsweise durch eine Hohlkathoden-Glimmentladung erfolgen, wobei die auf diesem Wege erfolgende Beschichtung vorzugsweise vor der Wärmebehandlung durchgeführt wird. Alternativ ist es auch möglich, die Plasmapolymerbeschichtung nach der Wärmebehandlung bei Atmosphärendruck mittels eines Atmosphären-Plasmas (AP-PACVD) zu erzeugen.

Nachfolgend wird die Erfindung anhand von Ausführungsbeispielen näher erläutert.

### Beispiel 1:

Auf ein Stahlblech, das aus niedriglegiertem, zum Kaltumformen bestimmten Stahl hergestellt ist, sind unmittelbar nach der elektrolytischen Abscheidung einer ca. 2 µm dicken Zink-Schicht mittels PVD-Technologien nacheinander zuerst eine ca. 300 nm dicke Magnesium-Schicht und anschließend eine ca. 200 nm dicke Aluminium-Schicht abgeschieden worden.

Anschließend ist eine ca. 250 nm dicke Plasmapolymerschicht mittels Hohlkathoden-Glimmentladung mit geerdeten Substraten unter Verwendung von Tetramethylsilan abgeschieden worden.

Durch eine danach durchgeführte, sich über eine Zeit von weniger als 30 s erstreckende Wärmebehandlung bei 330 - 360 °C ist schließlich ein dreischichtiger Zn-Al-Mg-Legierungsüberzug erzeugt worden, der aus einer Zn-Al-Schicht unmittelbar am Stahlsubstrat, einer sich daran anschließenden, überwiegend aus Zink bestehenden Zn-Schicht und einer unterhalb der Plasmapolymer-Schicht liegenden Zn-Al-Mg-Schicht besteht. Dies erfolgt im Zuge der Wärmebehandlung bei 330 - 360 °C dadurch, dass Aluminium aus der zuletzt aufgedampften Al-Schicht durch das darunter befindliche Magnesium und Zink hindurch diffundiert. Auf diese Weise reichert sich Al an der Grenzfläche Stahl-Zink an. Die bei diesen Temperaturen andernfalls zu erwartende Entstehung von Eisen-Zink-Phasen wird so wirkungsvoll verhindert.

Ein derart aufgebautes multifunktionelles Dünnschichtsystem zeigt eine Korrosionsstabilität des Bleches in Flanschproben gemäß SEP 1160 von mindestens 15 Zyklen im Korrosionswechseltest gemäß VDA Prüfblatt 621-415.

Gleichzeitig weist das in der hier beschriebenen Weise beschichtete erfindungsgemäße Stahlflachprodukt eine hervorragende Laserschweißeignung auf.

### Beispiel 2:

Für Korrosionsuntersuchun.gen wurden auf elektrolytisch verzinktes Stahlfeinblech nacheinander Magnesium und Titan mittels PVD-Techniken aufgedampft. Die Magnesiumschicht wurde dabei aus einem Molybdänschiffchen thermisch verdampft, während die Titanschicht mittels einer Sputter-Technologie aufgebracht worden ist.

Anschließend ist eine thermische Nachbehandlung der Probe bei 330 °C über einem Zeitraum von ca. 20 s durchgeführt worden.

Das sich dabei bildende Schichtsystem bestand aus einer auf dem Stahlsubstrat aufliegenden Zink-Schicht, einer sich darauf befindenden Zn-Mg-Legierungsschicht und einer an der Oberfläche befindlichen reinen Titan-Deckschicht.

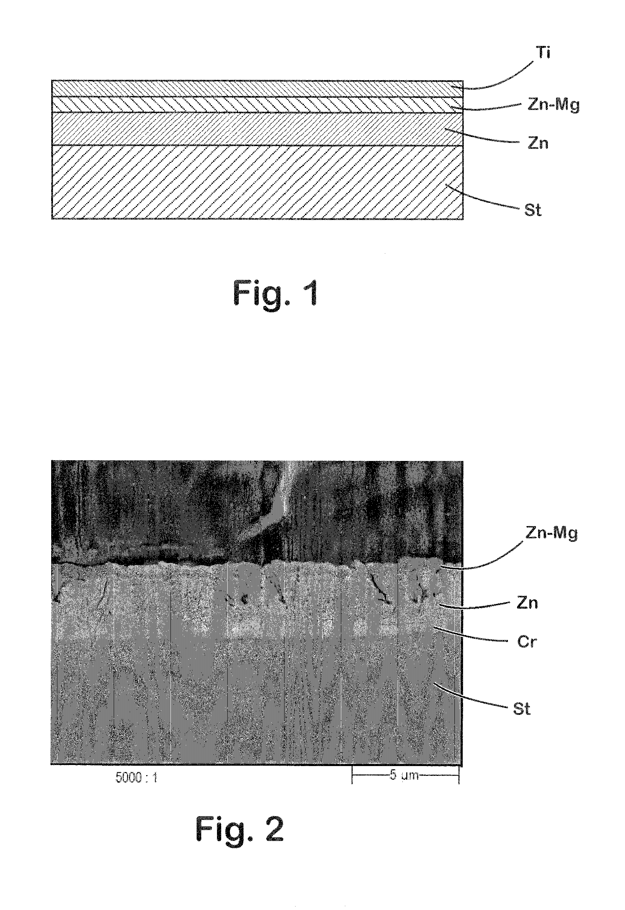

In Fig. 1 ist schematisch und nicht maßstäblich der nach der Wärmebehandlung erhaltene Schichtaufbau dargestellt. Mit "T1" ist darin die Titan-Deckschicht, mit "Zn-Mg" die Zn-Mg-Zwischenschicht, mit "Zn" die Zn-Schicht und mit "St" das als Grundschicht dienende Stahlblech bezeichnet.

### Beispiel 3:

Zur Herstellung eines Chrom-Zink-Magnesium-Überzugs ist ein in diesem Fall als Stahlsubstrat dienendes Feinblech zunächst rekristallisierend geglüht worden.

Anschließend ist das Stahlsubstrat auf eine Temperatur von etwa 100 °C abgekühlt worden.

In einem ersten Beschichtungsschritt ist dann mit einem PVD-Verfahren eine ca. 200 nm dicke Chrom-Schicht auf dem Stahlsubstrat abgeschieden worden.

In einem weiteren Schritt ist daraufhin ebenfalls mittels eines PVD-Verfahrens eine ca. 2 µm dicke Zn-Schicht auf der Cr-Schicht abgeschieden worden.

Auf diese Zn-Schicht ist schließlich wiederum mittels eines PVD-Verfahrens eine ca. 300 nm dicke Magnesium-Schicht abgeschieden worden.

Mittels einer bei einer Temperatur von 280 - 290 °C durchgeführten und sich über einen Zeitraum von etwa 20 s erstreckenden Diffusionswärmebehandlung ist auf dem so beschichteten Stahlsubstrat ein Cr-Zn-Mg-Legierungsüberzug ausgebildet worden.

Dieser Überzug bestand aus einer auf dem als Grundschicht dienenden Feinblech liegenden Chrom-Grundschicht, einer darauf liegenden Zink-Schicht und einer Zink-Magnesium-Deckschicht, die im Wesentlichen aus MgZn₂ bestand.

In Fig. 2 ist in einer Vergrößerung von 5000:1 ein Ausschnitt eines Schliffbilds dargestellt, aus dem der Schichtaufbau hervorgeht. Mit "Zn-Mg" ist darin die Zn-Mg-Deckschicht, mit "Zn" die Zn-Schicht, mit "Cr" die Cr-Schicht und mit "St" das als Grundschicht dienende Stahlblech bezeichnet.

Derart beschichtete und mit einem zusätzlichen Lack versehene Feinbleche wurden für Korrosionsuntersuchungen unter zyklischen Bedingungen nach VDA 621-415 verwendet.

Dazu wurde über einen bis in das Stahlsubstrat reichenden Ritz ein künstlicher Defekt eingebracht. Nach 10 Testzyklen zeigte sich gegenüber nur elektrolytisch verzinktem Feinblech und mit einem ZE-Mg-Überzug versehenem Feinblech eine deutlich geringere Delamination in der Umgebung des Ritzes.

### Beispiel 4:

Auf dem gemäß Beispiel 3 hergestellten Schichtsystem ist vor der thermischen Nachbehandlung mittels einer Hohlkathoden-Glimmentladung eine ca. 200 nm dicke Plasmapolymerschicht abgeschieden worden.

Anschließend erfolgte die Wärmebehandlung in der für das Beispiel 3 beschriebenen Weise.

Mit den auf diese Weise mit einem Cr-Zn-Mg-Überzug und einer darauf liegenden Plasmapoylmerschicht versehenen Stahlblechen konnte im Flanschkorrosionstest unter den Bedingungen des VDA-Wechseltests nach VDA-Prüfblatt 621-415 nach einer Prüfdauer von 15 Zyklen kein Rotrostbefall festgestellt werden.

### Beispiel 5:

Nach einem rekristallisierenden Glühen unter reduzierender Atmosphäre ist ein Feinblech auf eine Temperatur unterhalb von 150 °C abgekühlt worden.

Mittels PVD-Techniken sind anschließend nacheinander eine ca. 200 nm Aluminium-Schicht, darauf eine ca. 2 µm dicke Zink-Schicht und darauf eine ca. 300 nm dicke Magnesium-Schicht abgeschieden worden.

Mittels einer anschließenden Wärmebehandlung, bei der das beschichtete Stahlsubstrat für eine Dauer von ca. 10 - 15 s auf eine Temperatur von 300 - 320 °C aufgeheizt worden ist, konnte ein dreischichtiger Überzug hergestellt werden, der aus einer unmittelbar an das die Grundschicht bildende Feinbleich-Stahlsubstrat angrenzenden Aluminium-Schicht, einer darauf befindliche Zink-Schicht und einer an der Oberfläche befindlichen, überwiegend aus MgZn₂ bestehenden Schicht bestand.

Mit einem auf diese Weise hergestellten Stahlflachprodukt sind verschiedene Korrosionstests durchgeführt worden.

Im Standard-Salzsprühtest zeigte sich ein deutlich späterer Rotrostbefall gegenüber Stahlblechen, die als Korrosionsschutz mit einem 7,5 µm dicken reinen Zinküberzug bzw. einem 3,5 µm dicken Zink-Magnesium-Überzug versehen waren.

Die Ergebnisse der Salzsprühtests sind in Tabelle 1 zusammengefasst.

**Tabelle 1**

| Überzug: | **Al-Zn-Mg** | **Zn-Mg** | **Zn** |
|---|---|---|---|
| Erfindungsgemäß ? | JA | NEIN | NEIN |
| Dicke des Überzugs [µm] | ca. 2,5 | ca. 3,5 | Ca. 7,5 |
| Zeit bis zum ersten Rotrost [h] | 400-600 | 300-350 | 70-90 |

## Patentansprüche

1. Stahlflachprodukt mit einer aus einem Stahlwerkstoff hergestellten Grundschicht, auf die ein metallischer Überzug aufgetragen ist, bei dem mindestens drei Schichten ausgeprägt sind, von denen mindestens zwei teilweise miteinander legiert sind, wobei der Hauptbestandteil des Überzugs Zn ist, **dadurch gekennzeichnet,**
- **dass** die Dicke des Überzugs auf 3,5 µm beschränkt ist,
- **dass** der Überzug neben Zn mindestens zwei Elemente der Gruppe "Al, Mg, Ti, Cr, Mn" enthält,
- **dass** in dem Überzug mindestens eine Schicht ausgebildet ist, die mindestens ein Element der Gruppe "Al, Mg" oder eine Mischung dieser Elemente mit Zink enthält,
- **dass** optional in dem Überzug eine Zn-Schicht ausgebildet ist, die mindestens zu 80 Gew.-% aus Zn besteht,
- **dass** optional in dem Überzug eine Schicht ausgebildet ist, deren Bestandteil ein Element der Gruppe "Ti, Mn, Cr" ist, und
- **dass** optional der Überzug mit einer Plasmapolymerschicht beschichtet ist.

2. Stahlflachprodukt nach Anspruch 1, **dadurch gekennzeichnet, dass** die ein Element der Gruppe "Al,Mg" oder eine Mischung dieser Elemente mit Zn enthaltende Schicht zu mindestens 60 Gew.-% aus MgZn₂ besteht.

3. Stahlflachprodukt nach Anspruch 1, **dadurch gekennzeichnet, dass** die ein Element der Gruppe "Al,Mg" oder eine Mischung dieser Elemente mit Zn enthaltende Schicht eine Al-Zn-Schicht ist, die zu mindestens 60 Gew.-% aus Zn besteht.

4. Stahlflachprodukt nach Anspruch 1, **dadurch gekennzeichnet, dass** die ein Element der Gruppe "Al,Mg" oder eine Mischung dieser Elemente mit Zn enthaltende Schicht zu mindestens 50 Gew.-% aus Al besteht.

5. Stahlflachprodukt nach einem der voranstehenden Ansprüche, **dadurch gekennzeichnet, dass** die ein Element der Gruppe "Al,Mg" oder einer Mischung dieser Elemente mit Zn enthaltende Schicht max. 1000 nm dick ist.

6. Stahlflachprodukt nach einem der voranstehenden Ansprüche, **dadurch gekennzeichnet, dass** die Zn-Schicht 1 - 3,3 µm dick ist.

7. Stahlflachprodukt nach einem der voranstehenden Ansprüche, **dadurch gekennzeichnet, dass** die mindestens ein Element der Gruppe "Ti, Mn, Cr" enthaltende Schicht zu mindestens 75 Gew.-% aus dem jeweiligen Element besteht.

8. Stahlflachprodukt nach einem der voranstehenden Ansprüche, **dadurch gekennzeichnet, dass** die mindestens ein Element der Gruppe "Ti, Mn, Cr" enthaltende Schicht max. 600 nm dick ist.

9. Stahlflachprodukt nach einem der voranstehenden Ansprüche, **dadurch gekennzeichnet, dass** zwischen der mindestens ein Element der Gruppe "Ti, Mn, Cr" enthaltenden Schicht und einer daran angrenzenden anderen Schicht des Überzugs ein Übergangsbereich ausgebildet ist, in dem die Schichten gradiert ineinander legiert sind.

10. Stahlflachprodukt nach Anspruch 9, **dadurch gekennzeichnet, dass** der Übergangsbereich max. 1500 nm dick ist.

11. Stahlflachprodukt nach einem der voranstehenden Ansprüche, **dadurch gekennzeichnet, dass** die Dicke der auf dem Überzug liegenden Plasmapolymerschicht max. 1500 nm beträgt.

12. Verfahren zum Herstellen eines gemäß einem der Ansprüche 1 bis 11 ausgebildeten Stahlflachprodukts umfassend folgende Arbeitsschritte:
- Zurverfügungstellen eines Stahlsubstrats in Form eines Bandes oder Blechs;
- Vorbehandlung des Stahlsubstrats durch rekristallisierendes Glühen unter einer reduzierenden Atmosphäre und/oder durch Plasmnavorbohandeln;
- Beschichten des Stahlsubstrats mit mindestens drei unterschiedlichen Schichten, wobei die mindestens eine Schicht, deren überwiegender Bestandteil ein Elemente der Gruppe "Al,Mg" ist, und die optional zu erzeugende Schicht, deren überwiegender Bestandteil ein Element der Gruppe "Ti,Cr,Mn" ist, durch ein unter Vakuum durchgeführtes Abscheideverfahren aufgebracht werden;
- Wärmebehandeln des mit den mindestens drei Schichten belegten Stahlsubstrats, so dass ein dreischichtiger Überzug ausgebildet wird, bei dem mindestens zwei Schichten mindestens teilweise miteinander legiert sind;
- optionales Auftragen einer Plasmapolymerschicht auf den Überzug vor oder nach der Wärmebehandlung.

13. Verfahren nach Anspruch 12, **dadurch gekennzeichnet, dass** eine der Schichten des Überzugs durch elektrolytisches Beschichten aufgebracht wird.

14. Verfahren nach Anspruch 12, **dadurch gekennzeichnet, dass** eine der Schichten des Überzugs durch Tauchen in ein Schmelzenbad aufgebracht wird.

15. Verfahren nach einem der Ansprüche 12 bis 14,
**dadurch gekennzeichnet, dass** die Temperatur der Wärmebehandlung des Überzugs weniger als 500 °C beträgt.

16. Verfahren nach einem der Ansprüche 12 bis 15,
**dadurch gekennzeichnet, dass** die Wärmebehandlung in weniger als 60 Sekunden abgeschlossen wird.
